# EUROPÄISCHE PATENTANMELDUNG

(11) **EP 2 423 946 A1**
(43) Veröffentlichungstag der Anmeldung: **29.02.2012**
(21) Anmeldenummer: 10174051.2
(22) Anmeldetag: 25.08.2010
(51) Int. Cl.: H01L 21/02, H01L 21/20

(54) **Herstellung einer p-leitfähigen ZnO-haltigen Halbleiterschicht**

(71) Anmelder: Justus-Liebig-Universität Gießen, 35390 Giessen (DE)
(72) Erfinder: Meyer, Bruno, Prof. Dr., 35440 Großen-Linden (DE)
(74) Vertreter: Stumpf, Peter

(57) **Zusammenfassung**

Ein Verfahren zur Herstellung einer p-leitfähigen, ZnO-haltigen Halbleiterschicht umfasst das Zuführen einer gasförmigen Stickstoff-Wasserstoff-Verbindung in einen Reaktor während des Abscheidens der ZnO-haltigen Halbleiterschicht (S32), das Adsorbieren der Stickstoff-Wasserstoff-Verbindung an einer jeweils aktuellen Wachstumsoberfläche der ZnO-haltigen Halbleiterschicht (S34) und das Bilden eines Stickstoff-Wasserstoff-Komplexes in der ZnO-haltigen Halbleiterschicht als p-Leitfähigkeit bewirkende Akzeptorstruktur unter Verwendung der adsorbierten Stickstoff-Wasserstoff-Verbindung (S36).

## Beschreibung

Die vorliegende Erfindung betrifft ein Verfahren zur Herstellung einer p-leitfähigen Zinkoxid (ZnO)-haltigen Halbleiterschicht, bei dem diese in einem Reaktor auf einem Substrat abgeschieden wird. Die Erfindung betrifft weiterhin ein Verfahren zur Herstellung eines Halbleiterbauelements sowie ein Halbleiterbauelement umfassend ein Substrat und eine p-leitfähige ZnO-haltige Halbleiterschicht auf dem Substrat.

ZnO-haltige Halbleitermaterialien wie binäres ZnO und ternäres ZnMgO, ZnBeO oder ZnCdO, oder quaternäre ZnO-haltige Halbleitermaterialien wie ZnMgCdO, ZnBeCdO oder ZnMgBeO bilden ein alternatives Materialsystem zu den Gruppe-III-Nitrid-Halbleitern für die Herstellung von Halbleiterbauelementen, insbesondere von lichtemittierenden Halbleiterbauelementen wie Leuchtdioden und Laserdioden. Die ZnO-haltigen Halbleitermaterialien haben eine Bandlücke, die für optische oder optoelektronische Bauelemente geeignet ist, welche im grünen bis ultravioletten Spektralbereich arbeiten.

Als schwierig hat jedoch sich bisher die zuverlässige Herstellung von p-leitfähigem ZnO-haltigem Halbleitermaterial erwiesen. Als Akzeptoren eignen sich nach dem bekannten Stand der Technik insbesondere Elemente der Gruppe V des Periodensystems wie beispielsweise Arsen As, Phosphor P, Antimon Sb, und Stickstoff N. Aus der Gruppe I des Periodensystems ist die Verwendung von Lithium Li und Natrium Na zur p-Dotierung bekannt. Vereinzelt wird über p-Dotierung mit Kupfer Cu oder Silber Ag berichtet, wobei häufig die zugesetzten Dotierstoffe zugleich für die Bildung von Donatoren verantwortlich sind.

Aus der Veröffentlichung J. Huang et al., "Growth of N-doped p-type ZnO films using ammonia as dopant source gas", J. Mat. Sci. Lett. Vol. 22, 2003, 249-251, ist es bekannt, ZnO mit Stickstoff zu dotieren. Da Stickstoff eine geringe Löslichkeit in ZnO aufweist, wird zur Erhöhung der Löslichkeit von Stickstoff zunächst Stickstoff und Wasserstoff paarweise in Form von N-H im Rahmen eines Sputterprozesses in den aufwachsenden Kristall eingebaut und anschließend thermisch dissoziiert, um Stickstoff als Akzeptor im ZnO-haltigen Material zu aktivieren.

Aus der WO 2010/020224 A2 ist ein alternatives Verfahren zur Herstellung von p-dotierten, ZnO-haltigem Material bekannt, bei dem im Rahmen einer Schichtabscheidung mit der Molekularstrahlepitaxie (Molecular Beam Epitaxy, MBE) die p-Dotierung durch eine Stickstoff-Dotierung während des Wachstums unter Verwendung eines bestimmten Temperaturfensters, nämlich zwischen 150 und 400 °C erzielt wird. Die in diesem Dokument offenbarte Verfahrensführung bietet Stickstoff überwiegend atomar zum Einbau in den aufwachsenden Kristall an und vermeidet ausdrücklich den Einbau von Wasserstoff.

Das der vorliegenden Erfindung zugrunde liegende technische Problem ist es, ein alternatives, zuverlässiges Verfahren zur Herstellung einer p-leitfähigen, ZnO-haltigen Halbleiterschicht anzugeben.

Ein erster Aspekt der Erfindung betrifft ein Verfahren zur Herstellung einer p-leitfähigen, ZnO-haltigen Halbleiterschicht umfassend:
- Bereitstellen eines Substrats, und
- Abscheiden der p-leitfähigen ZnO-haltigen Halbleiterschicht auf dem Substrat in einem Reaktor.

Bei dem erfindungsgemäßen Verfahren wird die p-Leitfähigkeit wie folgt erzielt:
- Zuführen einer gasförmigen Stickstoff-Wasserstoff-Verbindung in den Reaktor während des Abscheidens der ZnO-haltigen Halbleiterschicht,
- Adsorbieren der Stickstoff-Wasserstoff-Verbindung an einer jeweils aktuellen Wachstumsoberfläche der ZnO-haltigen Halbleiterschicht und
- Bilden eines Stickstoff-Wasserstoff-Komplexes in der ZnO-haltigen Halbleiterschicht als p-Leitfähigkeit bewirkende Akzeptorstruktur unter Verwendung der adsorbierten Stickstoff-Wasserstoff-Verbindung.

Das erfindungsgemäße Verfahren beruht auf der Erkenntnis, dass Stickstoff als solcher nicht in der Lage ist, im ZnO und verwandten ZnO-haltigen Materialien die Löcherkonzentration im Valenzband und damit die p-Leitfähigkeit zu beeinflussen. Nach Erkenntnis der Erfinder bildet Stickstoff in ZnO einen tiefen Akzeptor, dessen energetischer Abstand von der Valenzbandoberkante mindestens 0,7 eV beträgt. Mit dem erfindungsgemäßen Verfahren gelingt dagegen der Einbau eines flachen Akzeptors, dessen energetischer Abstand zur Valenzbandkante nur 160 meV beträgt. Der erfindungsgemäß gebildete flache Akzeptor ist ein Stickstoff-Wasserstoff-Komplex, der sich in der ZnO-haltigen Halbleiterschicht während ihres Wachstums nach Adsorption der zugeführten gasförmigen Stickstoff/Wasserstoff-Verbindung bildet.

Im Gegensatz zur Verfahrensführung der WO 2010/020224 A2 ist also bei der erfindungsgemäßen Verfahrensführung die Gegenwart von Wasserstoff beim Wachstum der ZnO-haltigen Halbleiterschicht von großer Bedeutung. Im Gegensatz zum aus der eingangs genannten wissenschaftlichen Veröffentlichung von Huang et al. genannten Verfahrensführung ist für das erfindungsgemäße Verfahren wichtig, dass die adsorbierte Stickstoff-Wasserverbindung nach ihrem Einbau nicht in einer solchen Weise thermisch zersetzt wird, dass der Wasserstoff aus der ZnO-haltigen Halbleiterschicht entfernt wird. Eine Aktivierung durch Annealing oder einen sonstigen Prozess, bei dem die ZnO-haltige Halbleiterschicht einer Temperatur ausgesetzt wird, die Wasserstoff aus der Halbleiterschicht entfernt, ist bei der erfindungsgemäßen Verfahrensführung nicht notwendig.

Nach Erkenntnis der vorliegenden Erfinder bildet sich als p-Leitfähigkeit wirkende Akzeptorstruktur bei der erfindungsgemäßen Verfahrensführung ein Stickstoff-Wasserstoff-Komplex, welcher zwei Stickstoffatome auf nächst benachbarten Sauerstoff-Gitterplätzen enthält, die durch ein back-bonded Wasserstoffproton stabilisiert werden. Die Struktur lässt sich darstellen als N_{O}⁻N_{O}⁻H⁺. Diese Struktur entspricht formal einem Einfachakzeptor.

Nachfolgend werden Ausführungsbeispiele des erfindungsgemäßen Verfahrens beschrieben. Die zusätzlichen Merkmale der jeweiligen Ausführungsbeispiele können miteinander zur Bildung weiterer Ausführungsbeispiele kombiniert werden, soweit eine solche Kombination nicht ausgeschlossen wird, weil die Ausführungsbeispiele als Alternativen zueinander beschrieben werden.

Die ZnO-haltige Halbleiterschicht wird bei dem erfindungsgemäßen Verfahren vorzugsweise mit einem Gasphasenabscheide-Verfahren, und zwar bevorzugt epitaktisch abgeschieden. Auf diese Weise kann ein weitestgehend einkristallines Wachstum mit einer gegenüber Sputterverfahren geringen Defektkonzentration erreicht werden. Die Gasphasenabscheidung zeichnet sich darüberhinaus dadurch aus, dass sie für eine Produktion von Halbleiterbauelementen im industriellen Maßstab wirtschaftlicher ist.

Als Stickstoff-Wasserstoff-Verbindung, die während des Abscheidens der ZnO-haltigen Halbleiterschicht zugeführt wird, eignet sich insbesondere Ammoniak. Jedoch ist auch die Verwendung anderer gasförmiger Stickstoff-Wasserstoff-Verbindungen nicht ausgeschlossen.

Um die Stickstoff-Wasserstoff-Verbindung als solche an der jeweiligen Wachstumsoberfläche absorbieren lassen zu können, wird das Abscheiden vorzugsweise bei einer Temperatur durchgeführt, bei der zumindest ein Bruchteil einer im Reaktor befindlichen Menge der Stickstoff-Wasserstoff-Verbindung nicht thermisch in Stickstoff und Wasserstoff zersetzt wird, sondern zur Adsorption auf der Wachstumsoberfläche unzersetzt bereitsteht. Als geeigneter Temperaturbereich hat sich bei Verwendung von Ammoniak eine Substrat-Temperatur zwischen 200 °C und 600 °C erwiesen. Bei Verwendung anderer Stickstoff-Wasserstoff-Verbindungen kann dieser Temperaturbereich andere Grenzen aufweisen, je nach der thermischen Energie, die zur Zersetzung der Stickstoff-Wasserstoff-Verbindung aufgebracht werden muss.

Die Temperatur während der Schichtabscheidung kann dazu genutzt werden, den Wert der Akzeptorkonzentration und somit den Wert der zu erzielenden p-Leitfähigkeit einzustellen. Es hat sich herausgestellt, dass die p-Leitfähigkeit beim erfindungsgemäßen Verfahren um so größer ist, je geringer die Temperatur während des Wachstums der ZnO-haltigen Halbleiterschicht ist. Auch diese Verfahrensführung geht gegenüber der im einleitend beschriebenen Stand der Technik gegebenen Empfehlung, eine thermisch Zersetzung von Stickstoff und Wasserstoff in der aufwachsenden Halbleiterschicht anzustreben, völlig neue Wege. Bei dem vorliegenden Ausführungsbeispiel des erfindungsgemäßen Verfahrens führt gerade die Verwendung einer niedrigen Wachstumstemperatur wie beispielsweise 200 °C zu einer besonders hohen p-Leitfähigkeit. Eine thermische Zersetzung des Stickstoff-Wasserstoff-Komplexes würde die p-Dotierung zunichte machen.

Das erfindungsgemäße Verfahren eignet sich sowohl für die Homoepitaxie als auch für die Heteroepitaxie. Besonders gute Ergebnisse werden erzielt, wenn als Substrat für die aufwachsende ZnO-haltige Halbleiterschicht ein ZnO-Substrat verwendet wird, also ein homoepitaktisches Verfahren angewendet wird. Eine der Homoepitaxie ähnliche Situation kann dadurch erreicht werden, dass auf einem Fremdsubstrat wie beispielsweise Saphir oder Silizium zunächst eine Pufferschicht oder eine Folge mehrere Pufferschichten abgeschieden wird, auf welcher bzw. welchen dann eine Folge von ZnO-haltigen Halbleiterschichten abgeschieden wird.

Ein Substrat mit einer ZnO-haltigen Substratoberfläche wird vor dem Abscheiden der p-leitfähigen ZnO-haltigen Halbleiterschicht vorzugsweise einer Hochtemperatur-Behandlung unterzogen. Geeignet sind insbesondere Substrat-Temperaturen zwischen 1000°C und 1250°C. Bevorzugt wird die Hochtemperatur-Behandlung bei einer Substrat-Temperatur von 1150°C durchgeführt. Es hat sich herausgestellt, dass auf diese Weise auf der Substratoberfläche strukturelle Defekte im Substrat ausheilen und an der Substratoberfläche atomare Terrassenstrukturen erzeugt werden, die ein nachfolgendes epitaktisches Wachstum einer ZnO-haltigen Halbleiterschicht mit einer besonders geringen Defektdichte ermöglichen. Bei der Verwendung eines ZnO-Substrats ist ein weiterer Vorteil des Hochtemperatur-Ausheilschritts, dass das Substrat dadurch n-leitfähig gemacht werden kann, wenn es ursprünglich semi-isolierend, also hochohmig war.

Bevorzugt werden ZnO-haltige Substrate mit einer vor dem Abscheiden entweder Zn-polaren oder unpolaren Wachstumsfläche verwendet. Das Wachstum auf einer sauerstoffpolaren Oberfläche ist grundsätzlich ebenfalls möglich, führt jedoch zu einer höheren Hintergrunddotierung der aufwachsenden p-leitfähigen Halbleiterschicht. Dies erschwert die Erzielung einer hohen p-Leitfähigkeit.

Ein auf dem Verfahren des ersten Aspekts der Erfindung aufbauender zweiter Aspekt der Erfindung wird durch ein Verfahren zur Herstellung eines Halbleiterbauelements gebildet. Das Verfahren umfasst, in beliebiger Reihenfolge,
- Herstellen einer n-dotierten Halbleiterschicht, und
- Durchführen eines Verfahrens nach dem Verfahren des ersten Aspekts der Erfindung oder eines seiner in dieser Anmeldung beschriebenen Ausführungsbeispiele zum Herstellen einer p-dotierten, ZnO-haltigen Halbleiterschicht,
- wobei im Falle, dass zunächst die n-dotierte Halbleiterschicht hergestellt wird, diese als Substrat zum Herstellen der p-dotierten, ZnO-haltigen Halbleiterschicht verwendet wird.

Mit dem Verfahren des zweiten Aspekts der Erfindung gelingt die Herstellung von ZnObasierten Halbleiterbauelementen mit einem pn-Übergang. Solche Halbleiterbauelemente finden in elektronischen wie optoelektronischen Bauelementen Anwendung. Beispiele sind Leuchtdioden, Laserdioden, Licht-Detektoren, Dünnschicht-Transistoren, Varistoren oder Dünnschicht-Solarzellen.

Grundsätzlich wäre es unter wirtschaftlichen Erwägungen vorteilhaft, die gesamte Herstellung des Halbleiterbauelements in einem einzigen Reaktor nach einem einzigen Abscheideverfahren durchzuführen. Da es derzeit jedoch mit der Molekularstrahlepitaxie besonders gut gelingt, ZnO-basierte Heterostrukturen zur Lokalisierung von Ladungsträgern zu wachsen und n-leitfähige ZnO-Schichten herzustellen, wird in einem Ausführungsbeispiel das Herstellen der n-leitfähigen Halbleiterschicht mit einem Molekularstrahlepitaxie-Verfahren durchgeführt, während zum Herstellen der p-leitfähigen Halbleiterschicht ein Gasphasenepitaxie-Verfahren verwendet wird. Alternative Verfahren zur Herstellung der n-leitfähigen Halbleiterschicht, die mit dem erfindungsgemäßen Verfahren kombiniert werden können, sind die metallorganische Gasphasenepitaxie (Metal Organic Chemical Vapor Deposition, MOCVD) und die Physikalische Gasphasenabscheidung (Physical Vapor Deposition, PVD), beispielsweise in Form der Puls-Laser-Abscheidung (Pulsed Laser Deposition, PLD). Die Auswahl der weiteren Verfahrensmodule sollte berücksichtigen, dass bei der Verfahrensführung während und nach Herstellung der p-leitfähigen Schicht für die Erhaltung der p-Leitfähigkeit geeignete Prozesstemperaturen eingehalten, insbesondere nicht überschritten werden. Solche geeigneten Prozesstemperaturen verhindern also eine thermische Zersetzung der in die p-leitfähige Schicht eingebauten Akzeptorstruktur.

Das Herstellen der n-leitfähigen Halbleiterschicht umfasst dabei vorzugsweise einer Ladungsträger-lokalisierenden Schichtstruktur wie beispielsweise einer Quantentopf-Struktur. Auf diese Weise wird eine besonders starke Lichtemission bei Leuchtdioden und Laserdioden erzielt und kann bei Lichtdetektoren eine besonders hohe Empfindlichkeit erreicht werden.

Einen dritten Aspekt der Erfindung bildet ein Halbleiterbauelement, umfassend
- ein Substrat,
- eine p-leitfähige ZnO-haltige Halbleiterschicht auf dem Substrat,
- wobei die ZnO-haltige Halbleiterschicht als p-Leitfähigkeit bewirkende Akzeptorstruktur einen Stickstoff-Wasserstoff-Komplex enthält.

Das erfindungsgemäße Halbleiterbauelement zeichnet sich dadurch aus, dass es im industriellen Maßstab zuverlässig mit einer p-leitfähigen Schicht hergestellt werden kann. Es öffnet damit die Tür für eine größere Verbreitung ZnO-basierter Halbleiterbauelemente.

Nachfolgend werden Ausführungsbeispiele des erfindungsgemäßen Halbleiterbauelements beschrieben. Die zusätzlichen Merkmale der Ausführungsbeispiele können miteinander kombiniert werden, um weitere Ausführungsbeispiele zu bilden, es sei denn, die betreffende Ausführungsbeispiele sind als Alternativen zueinander beschrieben.

Als Substrat weist das erfindungsgemäße Halbleiterbauelement in einem Ausführungsbeispiel ein ZnO-Substrat auf. Hierbei handelt sich also um ein Homosubstrat.

Es ist jedoch alternativ auch ein Heterosubstrat verwendbar. Geeignete Beispiele sind Silizium oder Saphir. Silizium ist für Anwendungsfälle bevorzugt, bei denen das Substrat ein Halbleiter sein sollte und somit n- oder p-leitfähig gemacht werden kann. Zudem ist Silizium besonders kostengünstig und steht mit großen Wafer-Durchmessern zur Verfügung. Saphir ist dagegen für optische und optoelektronische Bauelemente günstig, bei denen im für ZnO-haltige Halbleiter relevanten blauen und ultravioletten Spektralbereich ein transparentes Substrat benötigt wird.

Bevorzugt ist auch bei Verwendung eines Heterosubstrats, dass angrenzend an die p-leitfähige ZnO-haltige Halbleiterschicht eine ebenfalls ZnO-haltige Substratschicht vorliegt. Dies ist durch Abscheidung einer ZnO-haltigen Pufferschichtstruktur auf dem Heterosubstrat erreichbar. Eine solche Struktur eines Heterosubstrats mit einer Pufferschicht oder einer Pufferschichtstruktur ist im Rahmen dieser Anmeldung ebenfalls als Ausführungsbeispiel eines Substrats, insbesondere eines Homosubstrats zu verstehen. Mit anderen Worten, als Substrat wird jede Oberfläche verstanden, auf der die p-leitfähige, ZnO-haltige Halbleiterschicht aufgewachsen ist.

Wie bereits im Zusammenhang des erfindungsgemäße Verfahrens zur Herstellung eines Halbleiterbauelements erläutert, weist das Halbleiterbauelement vorzugsweise eine zur Lokalisierung von Ladungsträgern geeignete n-leitfähige Einzelschicht oder Mehrschichtstruktur auf. Eine Einzelschicht kann in Verbindung mit der p-leitfähigen ZnO-haltigen Schicht eine Lokalisierung von Ladungsträgern bewirken, wenn sie zwischen dem Substrat und der p-leitfähigen Schicht eine für Ladungsträger attraktive Potentialstruktur bildet.

Geeignete Kontaktstrukturen für die p-leitfähige ZnO-haltige Halbleiterschicht enthalten oder bestehen aus Nickel und Gold. Für die Kontaktierung von n-leitfähigem ZnO-haltigem Material ist eine Al-haltige oder aus Aluminium bestehende Kontaktschicht geeignet.

Nachfolgend wird die erfindungsgemäße Verfahrensführung sowie das erfindungsgemä-βe Halbleiterbauelement anhand von weiteren Ausführungsbeispielen unter Bezugnahme auf die beigefügten Zeichnungen näher erläutert. Es zeigen:
Fig. 1 ein Flussdiagramm eines Ausführungsbeispiels eines Verfahrens zur Herstellung einer p-leitfähigen ZnO-haltigen Halbleiterschicht;
Fig. 2 ein Flussdiagramm, dass den Dotierungsprozess während des Wachstums der ZnO-haltigen Schicht näher beleuchtet;
Fig. 3 ein Diagramm, welches den gemessenen Stickstoff-Gehalt als Funktion der Wachstumstemperatur darstellt;
Fig. 4 ein Diagramm mit einer Folge von Photolumineszenzspektren verschiedener ZnO-Schichten, die sich in ihrem Stickstoffgehalt unterscheiden;
Fig. 5 eine schematische Querschnitts-Darstellung einer einfachen Bauelementstruktur mit einem pn-Übergang; und
Fig. 6 Kennlinien, also Diagramme der Stromstärke als Funktion der angelegten Spannung, die über den vorder- und rückseitigen Kontakten sowie über der Gesamtstruktur der Fig. 5 gemessen wurden.
Fig. 7 zeigt eine schematische Querschnittsansicht einer Lichtemitterstruktur als Ausführungsbeispiel eines erfindungsgemäßen Halbleiterbauelements.

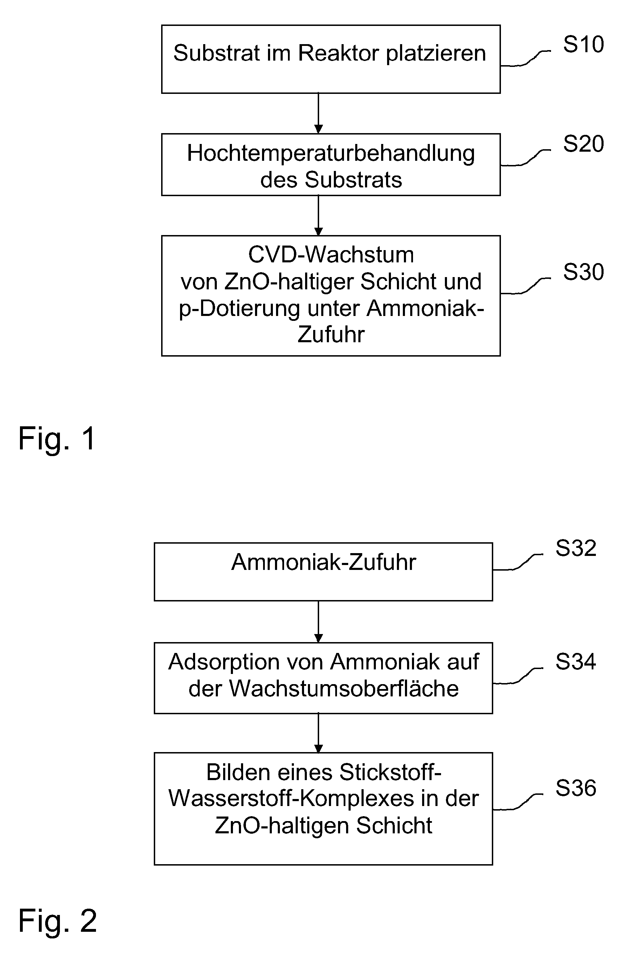

Fig. 1 zeigt ein Flussdiagramm eines Ausführungsbeispiels eines Verfahrens zur Herstellung einer p-leitfähigen ZnO-haltigen Halbleiterschicht.

In einem Schritt S10 wird ein Substrat in einen Reaktor eingeführt. Bei dem Reaktor handelt es sich im vorliegenden Ausführungsbeispiel um einen CVD-Reaktor (Chemical Vapor Deposition, Gasphasenabscheidung). Es kann beispielsweise ein vertikaler CVD-Reaktor verwendet werden.

Das Substrat wird anschließend in einem Schritt S20 einer Hochtemperaturbehandlung bei etwa 1150°C unterzogen. Diese Hochtemperaturbehandlung ist optional. Sie muss also nicht durchgeführt werden, um in einem nachfolgenden Schritt S30 eine p-leitfähige ZnO-haltige Halbleiterschicht herstellen zu können. Sie ist jedoch insofern vorteilhaft, als damit eine besonders günstige Substratoberfläche für das nachfolgende Wachstum der ZnO-haltigen Halbleiterschicht erreicht wird. Es bilden sich nämlich atomare Terrassenstrukturen, die das nachfolgende Wachstum mit hoher kristalliner Qualität günstig beeinflussen. Ein weiterer Vorteil der Hochtemperaturbehandlung des ZnO-Substrats ist, dass es mit diesem Verfahren von einem hochohmigen semi-isolierenden Zustand in einen n-leitfähigen Zustand konvertiert werden kann.

Beim vorliegenden Ausführungsbeispiel werden entweder Zn-polare oder unpolare Substratoberflächen verwendet. Unpolare Substratoberflächen entsprechen der sogenannten a-plane- oder m-plane Orientierung. Sauerstoffpolare (c-plane) Oberflächen werden vermieden, um beim nachfolgenden Schichtwachstum die Hintergrunddotierung mit intrinsischen Donatoren möglichst gering zu halten. Auf diese Weise kann eine möglichst hohe p-Leitfähigkeit erzielt werden.

In einem nachfolgenden Verfahrensschritt S30 wird die p-leitfähige ZnO-haltige Schicht aufgewachsen. Das Wachstum wird bei Substrat-Temperaturen im Bereich zwischen 200°C und 600 °C durchgeführt. Typische Werte des Reaktordrucks liegen zwischen 2 mbar und 40 mbar. Als Vorstufe zur Herstellung von ZnO werden für Sauerstoff NO₂ und für Zink metallisches Zink verwendet. Anstelle von NO₂ können auch andere Sauerstoff-Vorstufen verwendet werden. Grundsätzlich kann jedes sauerstoffhaltige Gas als Sauerstoff-Vorstufe verwendet werden. Geeignet sind beispielsweise auch N₂O, O₂ und CO₂. Das metallische Zink wird aus einer Metallschmelze verdampft und mit Hilfe eines Trägergases in den Bereich der Substratoberfläche transportiert. Als Trägergas kommt jedes Inertgas in Frage. Im vorliegend wird Stickstoff (N₂) oder Argon verwendet

Bei Herstellung von ternären oder quaternären ZnO-haltigen Halbleiterschichten können für die weiteren Elemente (Mg, Cd) der aufzuwachsenden Schicht im Stand der Technik bekannte gasförmige Vorstufen (Präkursoren) verwendet werden.

Nachfolgend wird unter Bezugnahme auf Fig. 2 näher erläutert, wie die Dotierung der ZnO-haltigen Halbleiterschicht durchgeführt wird. Als Dotierstoff wird während des Wachstums der Schicht gleichzeitig mit den anderen Gasen gasförmiges Ammoniak in den Reaktor eingeleitet. Die verwendeten Wachstumstemperaturen werden so gewählt, dass zumindest ein Bruchteil des zugeführten Ammoniaks unzersetzt zur Adsorption an der aktuellen Wachstumsoberfläche des ZnO-haltigen Materials zur Verfügung steht. Je tiefer die Wachstumstemperatur innerhalb des oben genannten Fensters zwischen 200 und 600 °C ist, desto größer ist der Bruchteil des Ammoniaks, welcher vor Adsorption an der Wachstumsoberfläche nicht zersetzt wird.

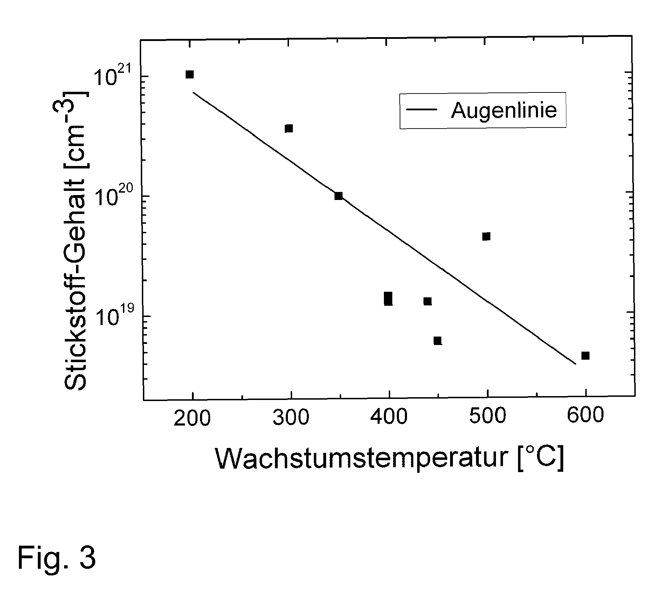

Es zeigt sich, dass auch der Einbau von Stickstoff in die aufwachsende ZnO-haltige Halbleiterschicht mit einer um so größeren Konzentration in Einheiten von cm⁻³ erfolgt, je geringer die Wachstumstemperatur innerhalb des genannten Fensters ist. In diesem Zusammenhang sei auf Fig. 3 verwiesen. Fig. 3 zeigt ein Diagramm, welches den gemessenen Stickstoff-Gehalt als Funktion der Wachstumstemperatur darstellt. In einer logarithmischen Darstellung ist der Stickstoffgehalt, also die Stickstoffkonzentration in Einheiten von cm⁻³ zwischen 10¹⁸ cm⁻³ und 10²¹ cm⁻³ als Funktion der Wachstumstemperatur zwischen 200 °C und 600 °C wiedergegeben. Die Stickstoffkonzentration wurde mit Hilfe der Sekundärionenmassenspektroskopie (SIMS) ermittelt. Messwerte sind durch gefüllte Quadrate symbolisiert. Zusätzlich ist eine durchgezogene Augenlinie in das Diagramm eingezeichnet. Ihr gerader Verlauf deutet an, dass der Einbau von Stickstoff mit steigender Wachstumstemperatur deutlich superlinear abfällt. Parallele Messungen der Wasserstoffkonzentrationen der untersuchten Proben ergaben, dass sich die Wasserstoffkonzentrationen von 5x10¹⁹ cm⁻³ bei einer Wachstumstemperatur von 200 °C auf 8x10¹⁷ cm⁻³ bei 500 °C verringert.

Es kann daher durch Einstellung der Wachstumstemperatur die Konzentration von Stickstoff in der aufwachsenden ZnO-haltigen Halbeiterschicht auf einen gewünschten Wert eingestellt werden. Zugleich kann damit auch die p-Leitfähigkeit gesteuert werden, da kein weiterer verfahrenstechnischer Schritt zur Aktivierung der sich nach Adsorption von Ammoniak in einem Schritt S36 bildenden Stickstoff-Wasserstoff-Komplexes erforderlich ist. Die Bildung des Stickstoff-Wasserstoff-Komplexes erfolgt unmittelbar während des Wachstums. Zu berücksichtigen ist, dass eine relativ niedrige Wachstumstemperatur die Schichtqualität der aufwachsenden ZnO-haltigen Halbleiterschicht beeinträchtigen und zu einer höheren Konzentration von Defekten führen kann, welche als Donator wirken zu einer teilweisen Kompensation der eingebauten Akzeptoren führt. Insofern entspricht der Zusammenhang zwischen Wachstumstemperatur und p-Leitfähigkeit nicht unmittelbar dem Zusammenhang zwischen Wachstumstemperatur und Stickstoffkonzentration.

Eine andere Möglichkeit der Einstellung der Konzentration des Stickstoff-Wasserstoff-Komplexes ist natürlich die Steuerung des Angebots ihrer Vorstufe, also im vorliegenden Ausführungsbeispiel von Ammoniak, im Reaktor.

Untersuchungen der Erfinder ergaben, dass im Bereich der Stickstoffkonzentration zwischen 10²¹ und 10²⁰ cm⁻³ eine entsprechende Paarkonzentration von 9x10¹⁹ bis 8x10¹⁷ cm⁻³ in der Schicht vorhanden ist. Diese Paarkonzentration korreliert mit der Wasserstoffkonzentration in der Schicht.

Nach derzeitiger Erkenntnis der Erfinder ist der Stickstoff-Wasserstoff-Komplex von zwei auf nächstbenachbarten Sauerstoffplätzen angeordneten Stickstoffatomen gebildet, welche durch ein Proton, also ein Wasserstoff-Ion zu einem Stickstoff-Wasserstoff-Komplex verbunden sind. Diese Struktur entspricht formal einem Einfachakzeptor. Die erläuterte Struktur des Akzeptors ist nur 160 meV oberhalb der Valenzbandoberkante und damit in einem Bereich, der für die Anwendung in elektrischen und optoelektronischen Bauelementen eine hinreichend hohe Aktivierung der Löcher an den Akzeptoren ermöglicht.

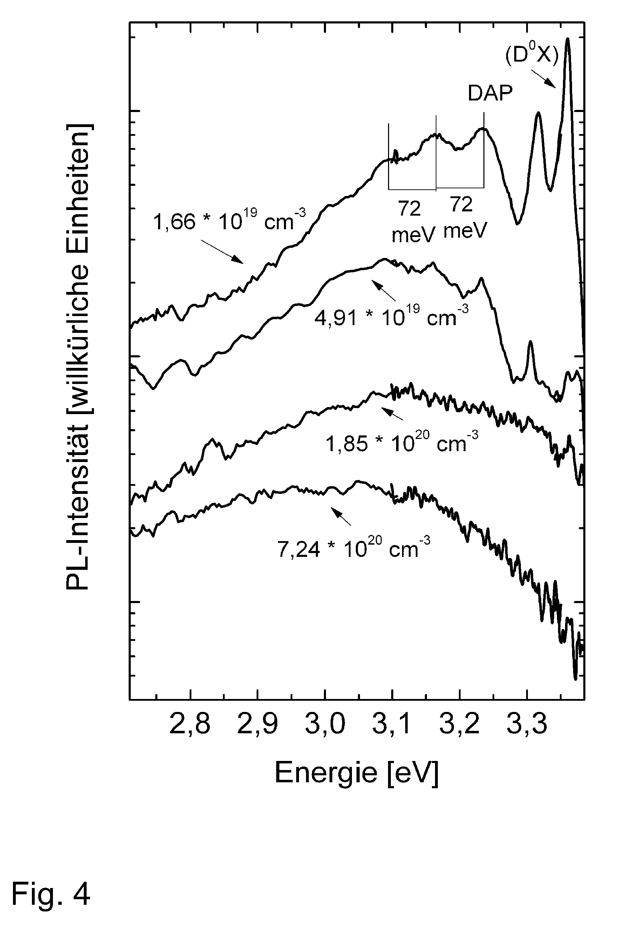

Fig. 4 zeigt ein Diagramm mit einer Folge von Photolumineszenzspektren verschiedener ZnO-Schichten, die sich in ihrem Stickstoffgehalt unterscheiden. Die in Fig. 4 dargestellten Photolumineszenzspektren zeigen die emittierte Lichtintensität in willkürlichen logarithmischen Einheiten als Funktion der Energie des emittierten Lichts in einem Spektralbereich zwischen etwa 2,7 und etwa 3,4 eV. Die dargestellten vier Spektren wurden an vier unterschiedlichen Proben gemessen, welche sich durch ihre Stickstoffkonzentration von einander unterscheiden. Der Stickstoffgehalt der gemessenen Proben steigt im Diagramm der Fig. 4 von oben nach unten. Mit anderen Worten: Das oberste dargestellte Spektrum stammt von einer Probe mit der geringsten Stickstoffkonzentration von 1,66x10¹⁹ cm⁻³. Das darunterliegende Spektrum stammt von einer Probe mit einer Stickstoffkonzentration von 4,1x10¹⁹ cm⁻³. Das dritte Spektrum von oben zeigt die Lumineszenz einer Probe mit einer Stickstoffkonzentration von 1,85x10²⁰ cm⁻³. Das unterste Spektrum zeigt die Lumineszenz einer Probe mit dem höchsten Stickstoffgehalt der für diesen Lumineszenzvergleich zusammengestellten Proben von 7,24x10²⁰ cm⁻³. Alle Spektren wurden bei Anregung der Probe mit einer Lichtenergie oberhalb der Bandlücke von Zinkoxid aufgenommen (Anregungslichtquelle HeCd-Laser, 10W/cm²). Die Spektren wurden bei einer Temperatur von etwa 4 K aufgenommen.

Das Spektrum der Probe mit der geringsten Stickstoffkonzentration zeigt ein für eine n-leitfähige ZnO-Schicht typisches Linienprofil. Die Lichtemission wird dominiert von dem Zerfall an einen neutralen Donator gebundener Exitonen, wobei Licht einer Energie von etwa 3,36 eV emittiert wird. Weiterhin erkennbar ist eine Lumineszenz bei 3,315 eV, die in der Fachliteratur unterschiedlichen Ursachen zugeordnet wird. Schließlich ist deutlich erkennbar eine Donator-Aktzeptor-Paar-Emission, deren Nullphononenlinie bei etwa 3,24 eV liegt und die zu niedrigeren Energien von charakteristischen Phononenreplika mit einem energetischen Abstand von 72 meV gefolgt ist.

Mit steigendem Stickstoffgehalt der mit dem erfinderungsgeäßen Verfahren hergestellten Proben verändert sich das Photoluminesenzspektrum deutlich zugunsten einer breitbandigen und sich zunehmend zu niedrigeren Energien hin verschiebenden Lichtemission, während exitonische Lumineszenz nach und nach vollständig verschwindet. Dieses Verhalten ist für p-dotierte, breitbandige Halbleitermaterialien typisch und wurde beispielsweise auch bei Magnesium-dotiertem Galliumnitrid beobachtet. Die Entwicklung der Lumineszenzspektren mit zunehmender Stickstoffdotierung ist ein deutliches Zeichen für einen Umschlag der Leitfähigkeit von n-leitend auf p-leitend im hier abgedeckten Intervall einer Stickstoffkonzentration von 1,66 x 10¹⁹cm⁻³ im Intervall einer Stickstoffkonzentration von etwa 7 x 10²⁰cm⁻³. In einem Zwischenstadium kompensieren die eingebrachten Stickstoffatome die intrinsische n-Leitfähigkeit und sorgen für semi-isolierendes Verhalten der Probe. Der Umschlagspunkt ist abhängig von der Hintergrunddotierung aufgrund intrinsischer Defekte, welche als Donatoren wirken.

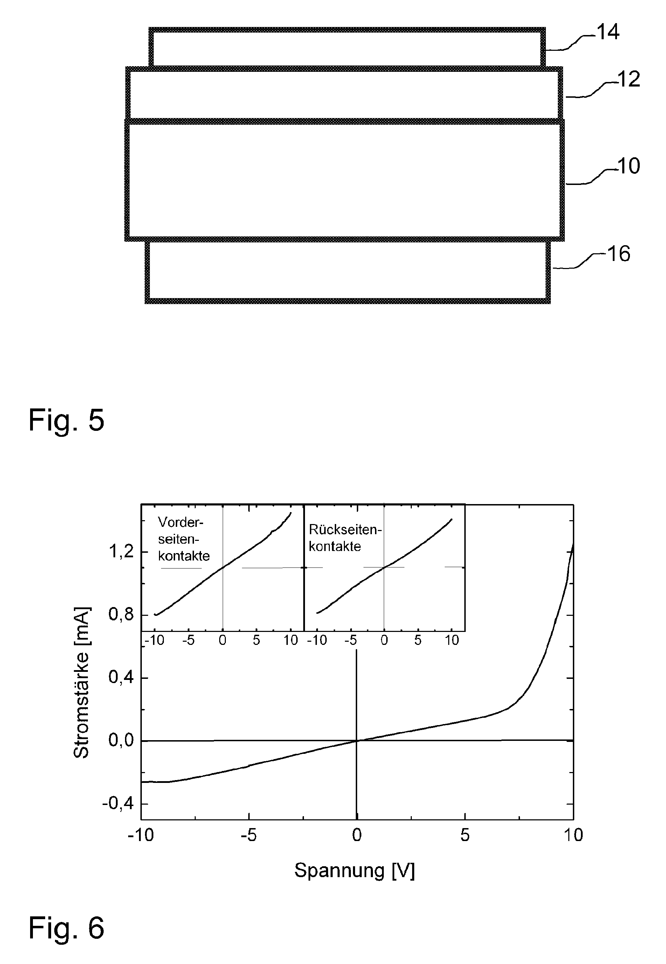

Fig. 5 zeigt eine schematische Darstellung einer einfachen Bauelementstruktur mit einem pn-Übergang. Die dargestellte einfache Struktur enthält ein ZnO-Substrat 10, das intrinsisch n-leitfähig ist und bei Bedarf zusätzlich mit Donatoren wie beispielsweise Aluminium dotiert werden kann. Auf dem ZnO-Substrat 10 ist eine mit Stickstoff (N) dotierte Zinkoxid-Schicht 12 abgeschieden. Die ZnO:N-Schicht 12 ist mit einem aus Nickel und Gold gefertigten Kontakt 14 versehen. Das Substrat 10 ist auf seiner Rückseite mit einem Aluminium-Kontakt 16 versehen.

Fig. 6 zeigt elektrische Kennlinien, also Diagramme der Stromstärke als Funktion der angelegten Spannung, die über den vorder- und rückseitigen Kontakten sowie über der Gesamtstruktur der Fig. 5 gemessen wurden. Die in Fig. 6 als Insets dargestellten Kennlinien zeigen für den Vorderseitenkontakt, also zwischen dem Ni/Au-Kontakt 14 und der ZnO:N-Schicht 12, ein ohmsches Verhalten. Dasselbe gilt für den rückseitigen Kontakt, der über der Al-Kontaktschicht 16 und dem ZnO-Substrat 10 vermessen wurde. Dagegen zeigt die Kennlinie, die zwischen dem Ni/Au-Kontakt 14 und dem Al-Kontakt 16 gemessen wurde, ein gewünschtes und typisches Diodenverhalten, das sich durch den bekannten exponentiellen Anstieg der Kennlinie auszeichnet, vorliegend oberhalb einer Spannung von etwa 7,5 V.

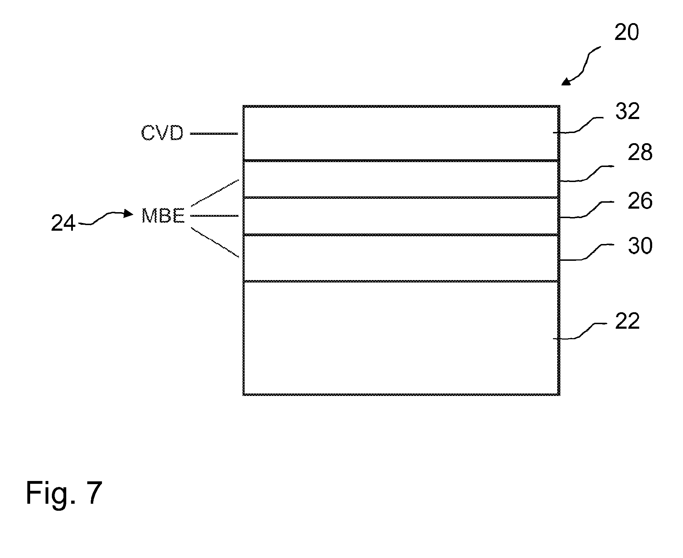

Fig. 7 zeigt eine schematische Querschnittsansicht einer Lichtemitterstruktur als Ausführungsbeispiel eines erfindungsgemäßen Halbleiterbauelements. Die Lichtemitterstruktur 20 der Figur 7 hat ein n-leitfähiges ZnO-Substrat 22, auf dem eine zur Lokalisierung von Ladungsträgern geeignete Quantentopf-Struktur 24 abgeschieden ist. Die Quantentop-Struktur 24 wird in an sich bekannter Weise der Schichtzusammenstellung aus binären, ternären oder quaternären ZnO-haltigen Halbleiterschichten hergestellt. Diese Struktur enthält im vorliegenden Beispiel eine ZnO-Schicht 26, die als Lokalisierungsschicht für Ladungsträger zwischen zwei Barrierenschichten, hier ZnMgO-Schichten 28 und 30 eingebettet ist. Die Quantentopf-Struktur 24 ist ebenfalls n-leitfähig. Viele alternative Schichtstruktur-Varianten sind möglich. Barrierenschichten können im vorliegenden Beispiel der Fig. 7 etwa auch mit ZnBeO anstelle von ZnMgO hergestellt werden. Wesentlich ist eine größere Bandlücke der Barrierenschichten im Vergleich mit der Lokalisierungsschicht, und die Bildung eines attraktiven Potentials sowohl für Elektronen als auch für Löcher im selben, zumindest in überlappenden Teilen der Schichtstruktur. Für Lichtemitter, die im grünen Spektralbereich leuchten, beispielsweise auch ZnCdO in der Lokalisierungsschicht 26 und ZnO in den Barrierenschichten 28 und 30 verwendet werden.

Auf der Quantentopf-Struktur 24 ist eine p-leitfähige ZnO-Schicht 32 abgeschieden, mit Hilfe derer also ein pn-Übergang hergestellt wird. Kontaktstrukturen sind der Einfachheit der Darstellung halber in Fig. 7 nicht eingezeichnet. Eine solches Bauelement 20 kann beispielsweise auf der Oberseite der ZnO-Schicht 32 und der Unterseite des ZnO-Substrats 20 kontaktiert und als Kantenemitter verwendet werden.

Die Quantentopf-Struktur 24 bildet ein attraktives Potential sowohl für Elektronen als auch für Löcher, welches im Betrieb bei Injizierung von Ladungsträgern über den pn-Übergang zur Lokalisierung beider Sorten Ladungsträger in der ZnO-Schicht und damit zur Erhöhung der Lichtemission führt. Die Quantentopf-Struktur 24 kann auch wiederholt vorhanden sein, um eine Multiquantentopfstruktur (multi quantum well, MQW) zu bilden.

Die Struktur der Fig. 7 kann so hergestellt werden, dass das Substrat 20 mit der darauf abgeschiedenen Quantenstruktur 22 mit Hilfe der Molekularstrahlepitaxie MBE gewachsen wird und die p-leitfähige ZnO-Schicht 28 darauf mit einem CVD-Verfahren abgeschieden wird. Dieses Herstellungsverfahren kombiniert die Vorteile der Molekularstrahlepitaxie, welche insbesondere die Möglichkeit zur Herstellung von Heterostrukturen wie der Quantentopf-Struktur 24 beinhalten, und der Gasphasenabscheidung, mit Hilfe derer eine zuverlässige p-Leitfähigkeit erzielt werden kann. Da die Wachstumstemperaturen im MBE-Verfahren und im CVD-Verfahren kaum voneinander abweichen, kann eine Degradation der Quantentopf-Struktur 22 beim CVD-Wachstum der p-leitfähigen ZnO-Schicht 28 vermieden werden.

## Patentansprüche

1. Verfahren zur Herstellung einer p-leitfähigen, ZnO-haltigen Halbleiterschicht (12, 32), umfassend:
- Bereitstellen eines Substrats (10, 24; S10);
- Abscheiden der p-leitfähigen ZnO-haltigen Halbleiterschicht (12) auf dem Substrat in einem Reaktor (S30);
**gekennzeichnet durch**
- Zuführen einer gasförmigen Stickstoff-Wasserstoff-Verbindung in den Reaktor während des Abscheidens der ZnO-haltigen Halbleiterschicht (S32);
- Adsorbieren der Stickstoff-Wasserstoff-Verbindung an einer jeweils aktuellen Wachstumsoberfläche der ZnO-haltigen Halbleiterschicht (S34); und
- Bilden eines Stickstoff-Wasserstoff-Komplexes in der ZnO-haltigen Halbleiterschicht als p-Leitfähigkeit bewirkende Akzeptorstruktur unter Verwendung der adsorbierten Stickstoff-Wasserstoff-Verbindung (S36).

2. Verfahren nach Anspruch 1, bei dem die ZnO-haltige Halbleiterschicht mit einem Gasphasenepitaxie-Verfahren abgeschieden wird.

3. Verfahren nach Anspruch 1 oder 2, bei dem als Stickstoff-Wasserstoff-Verbindung Ammoniak zugeführt wird.

4. Verfahren nach einem der vorstehenden Ansprüche, bei dem das Abscheiden (S30) bei einer Temperatur durchgeführt wird, bei der zumindest ein Bruchteil einer im Reaktor befindlichen Menge der Stickstoff-Wasserstoff-Verbindung nicht thermisch in Stickstoff und Wasserstoff zersetzt, sondern zur Adsorption auf der Wachstumsoberfläche bereitgestellt wird.

5. Verfahren nach Anspruch 4, bei dem das Abscheiden (S30) bei einer vorbestimmten, einem Wert der zu erzielenden p-Leitfähigkeit zugeordneten Temperatur durchgeführt wird, wobei eine umso geringere Temperatur zu wählen ist, je höher der Wert der zu erzielenden p-Leitfähigkeit ist.

6. Verfahren nach einem der vorstehenden Ansprüche, bei dem als Substrat ein ZnO-Substrat (10) verwendet wird.

7. Verfahren nach Anspruch 6, bei dem das Substrat vor dem Abscheiden einer Hochtemperatur-Behandlung (S12) unterzogen wird.

8. Verfahren nach Anspruch 6, bei dem Substrat (10) mit einer vor dem Abscheiden entweder Zn-polaren oder unpolaren Wachstumsoberfläche verwendet wird.

9. Verfahren zur Herstellung eines Halbleiterbauelements (20), umfassend, in beliebiger Reihenfolge,
- Herstellen einer n-dotierten Halbleiterschicht (24); und
- Durchführen eines Verfahrens nach einem der Ansprüche 1 bis 8 zum Herstellen einer p-dotierten, ZnO-haltigen Halbleiterschicht (32),
- wobei im Falle, dass zunächst die n-dotierte Halbleiterschicht (24) hergestellt wird, diese als Substrat zum Herstellen der p-dotierten, ZnO-haltigen Halbleiterschicht (32) verwendet wird.

10. Verfahren nach Anspruch 9, bei dem das Herstellen der n-dotierten Halbleiterschicht (24) mit einem Molekularstrahlepitaxie-Verfahren, einem metallorganischen Gasphasen-Abscheideverfahren oder einem physikalischen Gasphasen-Abscheideverfahren durchgeführt wird, während zum Herstellen der p-dotierten Halbleiterschicht (32) ein Chemisches Gasphasen-Abscheide-verfahren verwendet wird.

11. Verfahren nach Anspruch 9 oder 10, bei dem das Herstellen der n-dotierten Halbleiterschicht (24) das Herstellen einer Quantentopf-Struktur (26 bis 30) umfasst.

12. Halbleiterbauelement (20), umfassend
- ein Substrat (24);
- eine p-leitfähige ZnO-haltige Halbleiterschicht (32);
**dadurch gekennzeichnet, dass**
- die ZnO-haltige Halbleiterschicht (32) als p-Leitfähigkeit bewirkende Akzeptorstruktur einen Stickstoff-Wasserstoff-Komplex enthält.

13. Halbleiterbauelement nach Anspruch 12, bei dem das Substrat entweder vollständig aus ZnO gefertigt ist oder eine Schichtstruktur (24) aufweist, die angrenzend an die p-leitfähige ZnO-haltige Halbleiterschicht eine ZnO-haltige Substratschicht (28) aufweist.

14. Halbleiterbauelement nach Anspruch 12 oder 13, das angrenzend an die p-leitfähige ZnO-haltige Halbleiterschicht eine im Betrieb des Halbleiterbauelements zur Lokalisierung von Ladungsträgern geeignete n-leitfähige Einzelschicht oder Mehrschichtstruktur (24) aufweist.

15. Halbleiterbauelement nach Anspruch 12 oder 13, bei dem die p-leitfähige ZnO-haltige Halbleiterschicht mit einer Nickel und Gold enthaltenen Kontaktschicht (14) versehen ist.
